# EUROPEAN PATENT SPECIFICATION

(11) **EP 0 459 591 B1**
(45) Date of publication and mention of the grant of the patent: **04.09.1996**
(21) Application number: 91201320.8
(22) Date of filing: 30.05.1991
(51) Int. Cl.: C08G 59/38, C07D 303/24, C08G 59/62

(54) **Epoxy resin composition**
Epoxydharzzusammensetzung
Composition de résine époxyde

(30) Priority: 30.05.1990 US 530682
(43) Date of publication of application: 04.12.1991
(73) Proprietor: SHELL INTERNATIONALE RESEARCH MAATSCHAPPIJ B.V., NL-2596 HR Den Haag (NL)
(72) Inventor: Dangayach, Kailash Chandra Banwarilal, Houston, Texas 77083 (US)

(56) References cited:
- EP-A- 0 249 263
- US-A- 2 915 490
- US-A- 4 072 656
- CHEMICAL PATENTS INDEX, BASIC ABSTRACTS JOURNAL Week 9127, 4 September 1991 Derwent Publications Ltd., London, GB; AN 91-198589 & JP-A-3 124 758 (YUKA SHELL EPOXY KK) 28 May 1991

## Description

This invention relates to low-stress epoxy resin compositions useful in encapsulating electrical components.

Epoxy resins are used to encapsulate electrical components such as integrated circuits. The optimum properties for encapsulation resins include low melting point in the uncured state (to permit encapsulation of the component at a relatively low temperature), high glass transition temperature in the cured state (to permit encapsulation of a component which can tolerate high operating temperatures), low modulus and low coefficient of thermal expansion of the cured resin (properties related to the ability of the cured resin to resist "stress" or cracking at high operating temperatures), low viscosity (to permit high filler loading of the encapsulation formulation) and low chloride ion content (to minimize aluminum corrosion and resulting failure of the circuit).

A problem with epoxy resins for encapsulation, however, is that the conventional method of preparing epoxy resins involves the use of chlorine-containing starting materials. The presence of chloride ions in the resin used to encapsulate an electrical component promotes aluminum corrosion and can cause failure of the integrated circuit in use. The crystalline form of a given epoxy resin contains a relatively low chloride ion content and has relatively low melt viscosity; however, the crystalline form of a resin also has a relatively high melting temperature, making it necessary to use undesirably high temperatures during the encapsulation process.

One class of epoxy resins used in electrical encapsulation are epoxidized orthocresol novolac (EOCN) resins. EOCN resins have high glass transition temperatures, but they are difficult to process because of their high viscosities at temperatures normally desired for encapsulation.

Another class of epoxy resins suitable for electrical encapsulation are diglycidyl ethers of 3,3',5,5'-tetraalkyl-4,4'-dihydroxybiphenyls. These epoxy resins exhibit the highly desirable property combination of low melt viscosity and low modulus, the latter property being an indication of the ability of the cured composition to resist cracking during high temperature use. However, for some encapsulation applications, the glass transition temperature of these resins is undesirably low.

It is therefore an object of the invention to provide an epoxy resin composition which has low melt viscosity, a low melting point, low modulus and high glass transition temperature, which can be used in electrical encapsulation compositions.

The invention therefore relates to an epoxy resin composition comprising
(a) from 25 to 60 weight percent, based on the weight of components (a) and (b), of a diglycidyl ether of a 4,4'-dihydroxybiphenyl and
(b) from 75 to 40 weight percent of a polyglycidyl ether of a phenolic compound having an average epoxide functionality of at least 3.0, which can be represented by the structure 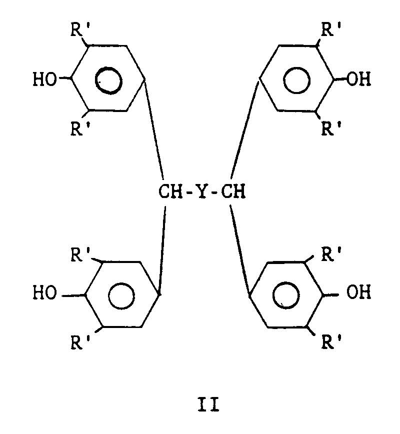 in which each R' is independently selected from hydrogen and C₁₋₄ alkyl and Y is a direct bond or a substituted or unsubstituted divalent hydrocarbyl linking group.
It was found that moulding powder compositions comprising the resin blend of the invention have low modulus and good processing viscosity at encapsulation temperatures.

Component (a) in the composition according to the invention can be described by chemical structure I: 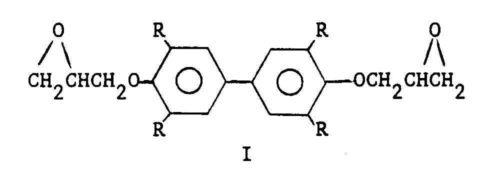 in which each R is selected independently from hydrogen and C₁₋₄ alkyl, preferably methyl or ethyl. The preferred component (a) is the diglycidyl ether of 3,3',5,5'-tetramethyl-4,4'-dihydroxybiphenyl.

The composition according to the invention further comprises a component (b) which can be described by chemical structure II as presented above.

Preferred groups R' are methyl and ethyl. Preferred linking groups Y are selected from (CH₂)₀₋₁₂ and (CH₂)ₘAr(CH₂)ₘ, in which m is 0-4 and Ar is a difunctional arylene moiety, preferably phenylene. Examples of such polyglycidyl ethers (b) are the polyglycidyl ethers of 1,1,2,2-tetrakis(4-hydroxyphenyl)ethane, 1,1,5,5-tetrakis(4-hydroxy-3,5-dimethylphenyl)pentane, 1,1,8,8-tetrakis(3-methyl-4-hydroxyphenyl)octane and α,α,α',α'-tetrakis(4-hydroxyphenyl)-p-xylene. In this context, a "poly" glycidyl ether is one having an average epoxide functionality of at least 3.0, preferably at least 3.5, per molecule. The preferred compound (b) is the tetraglycidyl ether of 1,1,2,2-tetrakis(4-hydroxy-3,5-dimethylphenyl)ethane. Such glycidyl ethers can be prepared by glycidating, by techniques known in the art, the corresponding tetraphenols, which can be prepared by condensing, in the presence of an acidic catalyst, an appropriate dialdehyde, such as glyoxal, isophthalaldehyde and terephthaldehyde, with a stoichiometric excess of a phenol.

The components (a) and (b) are present in the mixture in a molar ratio of (a) to (b) of from 25:75 to 60:40 weight percent, based on the weight of the mixture of the resins (a) and (b). For low modulus and optimum processability, the mixture preferably contains from 60 to 40, most preferably of from 55 to 45, weight percent of (b).

The preferred blends for electrical encapsulation applications exhibit a glass transition temperature above 180°C, preferably above 200°C, and a melting temperature below 120°C, preferably below 100°C. For maximum performance and low chloride ion content, resins will be selected which are manufactured or purified under conditions which result in crystalline diglycidyl ethers and tetraglycidyl ethers. A "crystalline" epoxy resin is characterized generally by narrow molecular weight distribution and a melting range of typically 20°C (as compared with an amorphous resin, which exhibits only softening with application of heat).

The two components of the resin composition of the invention can be combined in any manner which results in an intimate mixture of the epoxy resins. Melt-blending finely-divided particles of the two resins is preferred.

The epoxy resin composition of the invention will be used in combination with an effective amount of a curing agent. Suitable curing agents for epoxy resins include amines, phenols, anhydrides and imidazoles. The preferred curing agents for electrical encapsulation formulations are phenolic curing agents, including novolacs such as epoxidized orthocresol novolacs. The curing agent will be present in the composition in an amount effective to cure the epoxy resins, generally an amount within the range of from 1 to 100, preferably of from 30 to 60, weight percent, based on the total weight of (a) and (b). The composition can optionally include a cure accelerator such as a phosphine or an imidazole, generally present in an amount within the range of from 0.1 to 3 weight percent, based on the weight of the epoxy resins.

The composition according to the invention is useful in moulding, coating, adhesives and composites applications and has been found to be highly suitable for powder moulding applications such as encapsulation of an electrical component. Moulding compositions for electrical encapsulation will include an inert filler present in an amount of at least 55 weight percent, preferably of from 60 to 90 weight percent, based on the weight of the filled composition. Suitable inert fillers include silica, iron oxide, mica, alumina, talc, antimony trioxide, titanium oxide and the like. The preferred filler for electrical encapsulation formulations is silica. For composites applications, the epoxy resin blend will be used in combination with a fibrous reinforcement such as glass, carbon, quartz, poly(p-phenyleneterephthalamide), polyester, polytetrafluorethylene, poly(p-phenylenebenzobisthiazole), boron, paper, or like materials in chopped, mat or woven form.

The moulding formulation will typically contain one or more additives such as, for example, plasticizers, stabilizers, pigments, flow control agents and flame retardants. A brominated epoxy resin or brominated phenolic resin is commonly added to encapsulation formulations to provide flame retardancy. It is also common for the formulation to include an elastomer such as a rubbery butadiene/styrene copolymer, an organopolysiloxane polymer or copolymer, or a carboxy-terminated butadiene acrylonitrile for reduction of the modulus and enhancement of fracture toughness of the cured formulation.

The components of the moulding composition are combined so as to provide an intimate mixture of the ingredients of the moulding powder composition and thorough contact between the composition and the filler material. The preferred technique involves mixing the invention resin composition described above with a curing agent, any additives, and the filler, preferably after treatment of the filler with a silane or other coupling agent; grinding the mixture to about 35 mesh particles; dry-blending the particulate mixture; melt-mixing the blend in a roll mill or extruder at an elevated temperature about 15-30°C above the softening point of the blend; and grinding the solidified resin to about 35 mesh.

For encapsulation applications, the prepared formulation is cast around the electrical component to be encapsulated by a transfer moulding operation carried out at an elevated temperature sufficient to lower the viscosity of the resin so that it fills the mould and flows around the component, usually at temperatures of from 160-180°C, and an elevated pressure of 68.7 atm. The moulded parts are typically postcured for 1-6 hours at an elevated temperature to develop maximum physical properties.

### Example 1

Amounts as indicated in table 1, (runs 2, 3 and 4 according to the invention and runs 1, 5 and 6 for comparison) of the diglycidyl ether of 3,3',5,5'-tetramethyl-4,4'-dihydroxybiphenyl (DGE) and the tetraglycidyl ether of 1,1,2,2-tetrakis(4-hydroxy-3,5-dimethylphenyl)ethane (TGE) in powder form were weighed into a one-liter evaporating flask. (Each epoxy resin was crystalline and exhibited a melting range of about 20°C.) The flask was placed on a rotary evaporator equipped with a heated oil bath at 175°C. The flask was lowered into the bath and a full vacuum was applied. After 15 minutes, the flask was removed and inverted in a forced draft oven at 150°C. The molten resin mixture was allowed to drain into a glass container over the next 15 minutes. The container was removed and the resin blend was cooled to room temperature. The resulting solid blend was milled in a hammer mill to 35 mesh. Highest melting temperatures (peak maximum on differential scanning calorimeter) and heats of fusion for the blends of the two resins are shown in Table 1.

Table 1 shows that resins blends of the invention have a combination of low melting temperature and low heat of fusion.

**Table 1**

| Run | 1* | 2 | 3 | 4 | 5* | 6* |
|---|---|---|---|---|---|---|
| DGE/TGE (g/g) | 0/100 | 25/75 | 50/50 | 60/40 | 80/20 | 100/0 |
| Melting Temp. ( °C) | 166 | 150 | 99 | 100 | 103 | 106 |
| Heat of Fusion (Cal/g) | 10.6 | 2.1 | 0.8 | 5.7 | 10.1 | 12 |

| | | | | | | |
|---|---|---|---|---|---|---|
| * for comparison | | | | | | |

### Example 2

A moulding composition I according to the invention was prepared by blending, for one hour in a Turbula mixer, the components listed in table 2. The curing agent was Durite SD-1711 (Durite is a trade mark) phenolic novolac from Borden Chemical Co., present in a 85% stoichiometric amount, based on the epoxy resin blend. The brominated epoxy novolac was added for flame retardancy. Triphenylphosphine was used as a cure accelerator.

This mixture was blended with fused silica filler coated with a silane coupling agent, and the blend was mixed for one hour in the Turbula mixer. The filled moulding powder formulation was then melt-blended in a twin-screw extruder at 105°C. The extruded compound was allowed to cool and was then milled in a blender to 16 mesh. 2.54 x 7.62 x 0.32 cm test pieces were moulded in an RTM press by heating for four minutes at 175°C and postcuring for 4 hours at 175°C.

For comparison, moulding powder compositions II and III were prepared from each of a commercial epoxidized ortho cresol novolac (EOCN-1027 epoxy resin from Nippon Kayaku having a WPE of 193 and from a diglycidyl ether of 3,3',5,5'-tetramethyl-4,4'-dihydroxybiphenyl (DGE) having a WPE of 185 by mixing the components as listed in table 2, as described above. Test pieces we prepared in a similar manner as described for composition I.

**Table 2 (g)**

| Composition | I | II* | III* |
|---|---|---|---|
| Epoxy blend run 3, ex 1 | 102 | - | - |
| EOCN | - | 75 | - |
| DGE | - | - | 75 |
| Brominated expoxy novalac | 10.2 | 7.5 | 7.5 |
| Phenolic curing agent | 67.1 | 47.9 | 50.5 |
| Antimony oxide | 10.2 | 7.5 | 7.5 |
| Carnuba wax | 2.03 | 1.50 | 1.50 |
| Triphenyl-phosphine | 3.05 | 0.75 | 2.25 |
| Fused silica | 453 | 323 | 337 |

| | | | |
|---|---|---|---|
| * for comparison | | | |

Properties of the test specimens of compositions I, II and III are shown in Table 3. Also shown in Table 3 are melt viscosities of the resin blend and the comparison resins.

**Table 3**

| Composition | I | II* | III* |
|---|---|---|---|
| Tg, °C, Tan Delta | 212 | 216 | 174 |
| Tg, °C, TMA | 173 | 173 | 149 |

| CTE, ppm/°C | | | |
|---|---|---|---|
| 50-100 °C Range | 23.8 | 24 | 24.8 |
| 220-240 °C Range | 74.7 | 80 | 86.1 |

| Flex Properties | | | |
|---|---|---|---|
| Strength, atm.10³ | 1.24 | 1.37 | 1.28 |
| Modulus, atm.10³ | 140 | 161 | 140 |
| % Elongation | 1.0 | 0.9 | 1.0 |
| CTE.Modulus, atm.10⁶/°C | 1.15 | 3.86 | 1.25 |
| Viscosity (mPa/s, 150 °C) | 47 | 844 | <0.1 |
| (neat resin)(mPa/s, 180 °C) | 18 | 224 | <0.1 |

| | | | |
|---|---|---|---|
| * for comparison | | | |

As can be seen from Table 2, the composition comprising the epoxy blend according to the invention has a high Tg comparable to that of the composition comprising the EOCN resin and significantly higher than that of the composition comprising the DGE alone. At the same time, the coefficient of thermal expansion (CTE.modulus) of moulding powder composition I is significantly lower than that of composition II and is comparable to that of composition III. Furthermore, the melt viscosity of the composition I is significantly lower than that of composition II.

## Claims (Claims for the following Contracting State(s): BE, DE, FR, GB, IT, NL)

1. A composition comprising:
(a) from 25 to 60 weight percent, based on the weight of components (a) and (b), of a diglycidyl ether of a 4,4'-dihydroxybiphenyl and
(b) from 75 to 40 weight percent of a polyglycidyl ether of a phenolic compound having an average epoxide functionality of at least 3.0, which can be represented by the structure 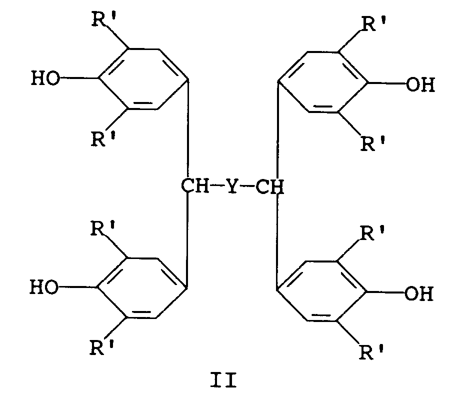 in which each R' is independently selected from hydrogen and C₁₋₄ alkyl and Y is a direct bond or a substituted or unsubstituted divalent hydrocarbyl linking group.

2. A composition as claimed in claim 1 in which Y is selected from the groups (CH₂)₀₋₁₂ and (CH₂)ₘAr(CH₂)ₘ, in which m is 0-4 and Ar is phenylene.

3. A composition as claimed in claim 1 or 2, in which component (a) is a diglycidyl ether of a 3,3',5,5'-tetraalkyl-4,4'-dihydroxybiphenyl.

4. A composition as claimed in claim 3 in which component (a) is a diglycidyl ether of 3,3',5,5'-tetramethyl-4,4'-dihydroxybiphenyl.

5. A composition as claimed in any one of claims 1 to 4 in which component (b) is a crystalline polyglycidyl ether of an α,α,Ω,Ω-tetrakis(4-hydroxy-3,5-dialkylphenyl)alkane having an average epoxide functionality of at least 3.0.

6. A composition as claimed in claim 5, in which component (b) is a polyglycidyl ether of 1,1,2,2-tetrakis(4-hydroxy-3,5-dimethylphenyl) ethane.

7. A composition as claimed in any one of the claims 1 to 6 which further comprises an effective amount of a curing agent for components (a) and (b).

8. A composition as claimed in claim 7 in which the curing agent is a phenolic compound.

9. An article of manufacture comprising the cured composition of claim 7 or 8.

## Claims (Claims for the following Contracting State(s): ES)

1. A process for the preparation of a composition by making an intimate mixture of two components, characterized in that one component is
(a) from 25 to 60 weight percent, based on the weight of components (a) and (b), of a diglycidyl ether of a 4,4'-dihydroxybiphenyl, and the other component is
(b) from 75 to 40 weight percent of a polyglycidyl ether of a phenolic compound having an average epoxide functionality of at least 3.0, which can be represented by the structure 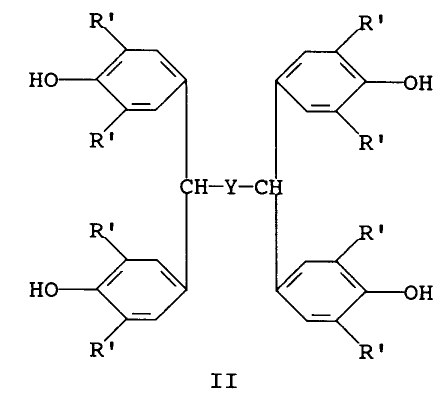 in which each R' is independently selected from hydrogen and C₁₋₄ alkyl and Y is a direct bond or a substituted or unsubstituted divalent hydrocarbyl linking group.

2. A process as claimed in claim 1 in which Y is selected from the groups (CH₂)₀₋₁₂ and (CH₂)ₘAr(CH₂)ₘ, in which m is 0-4 and Ar is phenylene.

3. A process as claimed in claim 1 or 2, in which component (a) is a diglycidyl ether of a 3,3',5,5'-tetraalkyl-4,4'-dihydroxybiphenyl.

4. A process as claimed in claim 3 in which component (a) is a diglycidyl ether of 3,3',5,5'-tetramethyl-4,4'-dihydroxybiphenyl.

5. A process as claimed in any one of claims 1 to 4 in which component (b) is a crystalline polyglycidyl ether of an α,α,Ω,Ω-tetrakis(4-hydroxy-3,5-dialkylphenyl)alkane having an average epoxide functionality of at least 3.0.

6. A process as claimed in claim 5, in which component (b) is a polyglycidyl ether of 1,1,2,2-tetrakis(4-hydroxy-3,5-dimethylphenyl) ethane.

7. A process as claimed in any one of the claims 1 to 6 which further comprises an effective amount of a curing agent for components (a) and (b).

8. A process as claimed in claim 7 in which the curing agent is a phenolic compound.

## Patentansprüche (Patentansprüche für folgende(n) Vertragsstaat(en): BE, DE, FR, GB, IT, NL)

1. Zusammensetzung, enthaltend
(a) 25 bis 60 Gewichtsprozent, bezüglich des Gewichtes der Komponenten (a) und (b), eines Diglycidylethers eines 4,4'-Dihydroxybiphenyls und
(b) 75 bis 40 Gewichtsprozent eines Polyglycidylethers einer phenolischen Verbindung mit einer mittleren Epoxyfunktionalität von mindestens 3,0, welche durch die Strukturformel 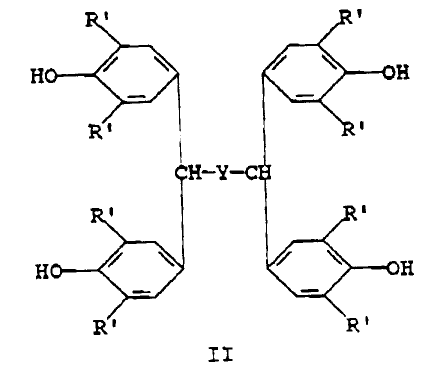 dargestellt werden kann, in der jedes R' unabhängig aus Wasserstoff und C₁-C₄-Alkyl ausgewählt ist und Y eine Direktbindung oder eine gegebenenfalls substituierte zweiwertige Hydrocarbyl-Verknüpfungsgruppe bedeutet.

2. Zusammensetzung nach Anspruch 1, wobei man Y aus den Gruppen (CH₂)₀₋₁₂ und (CH₂)ₘAr(CH₂)ₘ auswählt, wobei m 0-4 ist und Ar Phenylen bedeutet.

3. Zusammensetzung nach Anspruch 1 oder 2, wobei es sich bei der Komponente (a) um einen Diglycidylether eines 3,3',5,5'-Tetraalkyl-4,4'-dihydroxybiphenyls handelt.

4. Zusammensetzung nach Anspruch 3, wobei es sich bei der Komponente (a) um einen Diglycidylether eines 3,3',5,5'-Tetramethyl-4,4'-dihydroxybiphenyls handelt.

5. Zusammensetzung nach einem der Ansprüche 1 bis 4, wobei es sich bei der Komponente (b) um einen kristallinen Polyglycidylether eines α,α,Ω,Ω-Tetrakis(4-hydroxy-3,5-dialkylphenyl)alkans mit einer mittleren Epoxyfunktionalität von mindestens 3,0 handelt.

6. Zusammensetzung nach Anspruch 5, wobei es sich bei der Komponente (b) um einen Polyglycidylether eines 1,1,2,2-Tetrakis(4-hydroxy-3,5-dimethylphenyl)ethans handelt.

7. Zusammensetzung nach einem der Ansprüche 1 bis 6, die weiterhin eine wirksame Menge eines Vernetzungsmittels für die Komponenten (a) und (b) enthält.

8. Zusammensetzung nach Anspruch 7, wobei es sich bei dem Vernetzungsmittel um eine phenolische Verbindung handelt.

9. Ein Fertigartikel, welcher die gehärtete Zusammensetzung aus Anspruch 7 oder 8 enthält.

## Patentansprüche (Patentansprüche für folgende(n) Vertragsstaat(en): ES)

1. Verfahren zur Herstellung einer Zusammensetzung, durch das innige Vermischen zweier Komponenten dadurch gekennzeichnet, daß die eine Komponente
(a) 25 bis 60 Gewichtsprozent, bezüglich des Gewichtes der Komponenten (a) und (b), eines Diglycidylethers eines 4,4'-Dihydroxybiphenyls und die andere Komponente
(b) 75 bis 40 Gewichtsprozent eines Polyglycidylethers einer phenolischen Verbindung mit einer mittleren Epoxyfunktionalität von mindestens 3,0, welche durch die Strukturformel 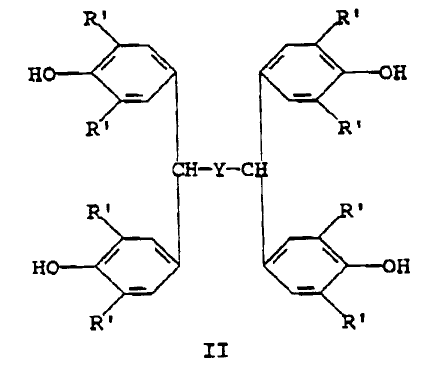 dargestellt werden kann, in der jedes R' unabhängig aus Wasserstoff und C₁-C₄-Alkyl ausgewählt ist und Y eine Direktbindung oder eine gegebenenfalls substituierte zweiwertige Hydrocarbyl-Verknüpfungsgruppe bedeutet, darstellt.

2. Verfahren nach Anspruch 1, wobei man Y aus den Gruppen (CH₂)₀₋₁₂ und (CH₂)ₘAr(CH₂)ₘ auswählt, wobei m 0-4 ist und Ar Phenylen bedeutet.

3. Verfahren nach Anspruch 1 oder 2, wobei es sich bei der Komponente (a) um einen Diglycidylether eines 3,3',5,5'-Tetraalkyl-4,4'-dihydroxybiphenyls handelt.

4. Verfahren nach Anspruch 3, wobei es sich bei der Komponente (a) um einen Diglycidylether eines 3,3',5,5'-Tetramethyl-4,4'-dihydroxybiphenyls handelt.

5. Verfahren nach einem der Ansprüche 1 bis 4, wobei es sich bei der Komponente (b) um einen kristallinen Polyglycidylether eines α,α,Ω,Ω-Tetrakis(4-hydroxy-3,5-dialkylphenyl)alkans mit einer mittleren Epoxyfunktionalität von mindestens 3,0 handelt.

6. Verfahren nach Anspruch 5, wobei es sich bei der Komponente (b) um einen Polyglycidylether eines 1,1,2,2-Tetrakis(4-hydroxy3,5-dimethylphenyl)ethans handelt.

7. Verfahren nach einem der Ansprüche 1 bis 6, das weiterhin eine wirksame Menge eines Vernetzungsmittels für die Komponenten (a) und (b) umfaßt.

8. Verfahren nach Anspruch 7, wobei es sich bei dem Vernetzungsmittel um eine phenolische Verbindung handelt.

## Revendications (Revendications pour l'(les) Etat(s) contractant(s) suivant(s): BE, DE, FR, GB, IT, NL)

1. Composition, caractérisée en ce qu'elle comprend :
(a) de 25 à 60% en poids, sur base du poids des composants (a) et (b), d'un éther diglycidylique d'un 4,4'-dihydroxybiphényle, et
(b) de 75 à 40% en poids d'un éther polyglycidylique d'un composé phénolique possédant une fonctionnalité époxyde d'au moins 3,0 et que l'on peut représenter par la structure suivante : 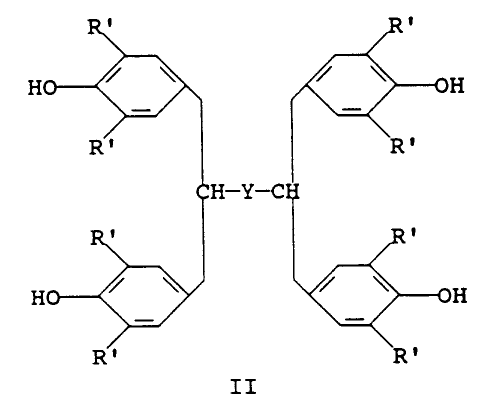 dans laquelle chaque symbole R' est indépendamment choisi parmi l'hydrogène et les radicaux alkyle en C₁ à C₄ et Y représente une liaison directe ou un groupe de liaison hydrocarbyle bivalent, substitué ou non substitué.

2. Composition suivant la revendication 1, caractérisée en ce que Y est choisi parmi les groupes (CH₂)₀₋₁₂ et (CH₂)ₘAr(CH₂)ₘ, où m a une valeur de 0 à 4 et Ar est le radical phénylène.

3. Composition suivant l'une quelconque des revendications 1 et 2, caractérisée en ce que le composant (a) est un éther diglycidylique d'un 3,3',5,5'-tétraalkyl-4,4'-dihydroxybiphényle.

4. Composition suivant la revendication 3, caractérisée en ce que le composant (a) est l'éther diglycidylique du 3,3',5,5'-tétraméthyl-4,4'-dihydroxybiphényle.

5. Composition suivant l'une quelconque des revendications 1 à 4, caractérisée en ce que le composant (b) est un éther polyglycidylique cristallin d'un α,α,Ω,Ω-tétrakis(4-hydroxy-3,5-dialkylphényl)alcane possédant une fonctionnalité époxyde moyenne d'au moins 3,0.

6. Composition suivant la revendication 5, caractérisée en ce que le composant (b) est l'éther polyglycidylique du 1,1,2,2-tétrakis(4-hydroxy-3,5-diméthylphényl)éthane.

7. Composition suivant l'une quelconque des revendications 1 à 6, caractérisée en ce qu'elle comprend, en outre, une proportion efficace d'un agent de durcissement pour les composants (a) et (b).

8. Composition suivant la revendication 7, caractérisée en ce que l'agent de durcissement est un composé phénolique.

9. Article de fabrication, comprenant la composition durcie suivant l'une quelconque des revendications 7 et 8.

## Revendications (Revendications pour l'(les) Etat(s) contractant(s) suivant(s): ES)

1. Procédé de préparation d'une composition en réalisant un mélange intime de deux composants, caractérisé en ce que l'un des composants est constitué
(a) de 25 à 60% en poids, sur base du poids des composants (a) et (b), d'un éther diglycidylique d'un 4,4'-dihydroxybiphényle, et l'autre composant est constitué
(b) de 75 à 40% en poids d'un éther polyglycidylique d'un composé phénolique possédant une fonctionnalité époxyde d'au moins 3,0 et que l'on peut représenter par la structure suivante : 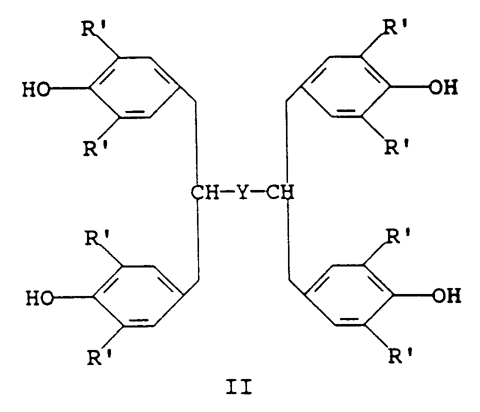 dans laquelle chaque symbole R' est indépendamment choisi parmi l'hydrogène et les radicaux alkyle en C₁ à C₄ et Y représente une liaison directe ou un groupe de liaison hydrocarbyle bivalent, substitué ou non substitué.

2. Procédé suivant la revendication 1, caractérisé en ce que Y est choisi parmi les groupes (CH₂)₀₋₁₂ et (CH₂)ₘAr(CH₂)ₘ, où m a une valeur de 0 à 4 et Ar est le radical phénylène.

3. Procédé suivant l'une quelconque des revendications 1 et 2, caractérisé en ce que le composant (a) est un éther diglycidylique d'un 3,3',5,5'-tétraalkyl-4,4'-dihydroxybiphényle.

4. Procédé suivant la revendication 3, caractérisé en ce que le composant (a) est l'éther diglycidylique du 3,3',5,5'-tétraméthyl-4,4'-dihydroxybiphényle.

5. Procédé suivant l'une quelconque des revendications 1 à 4, caractérisé en ce que le composant (b) est un éther polyglycidylique cristallin d'un α,α,Ω,Ω-tétrakis(4-hydroxy-3,5-dialkylphényl)alcane possédant une fonctionnalité époxyde moyenne d'au moins 3,0.

6. Procédé suivant la revendication 5, caractérisé en ce que le composant (b) est l'éther polyglycidylique du 1,1,2,2-tétrakis(4-hydroxy-3,5-diméthylphényl)éthane.

7. Procédé suivant l'une quelconque des revendications 1 à 6, caractérisé en ce qu'il comprend, en outre, une proportion efficace d'un agent de durcissement pour les composants (a) et (b).

8. Procédé suivant la revendication 7, caractérisé en ce que l'agent de durcissement est un composé phénolique.
